# EUROPÄISCHE PATENTSCHRIFT

(11) **EP 3 690 967 B1**
(45) Veröffentlichungstag und Bekanntmachung des Hinweises auf die Patenterteilung: **14.07.2021**
(21) Anmeldenummer: 20164570.2
(22) Anmeldetag: 11.11.2016
(51) Int. Cl.: H01L 41/04, H02N 2/06, H05B 41/282

(54) **ANSTEUERSCHALTUNG UND VERFAHREN ZUR ANSTEUERUNG EINES PIEZOELEKTRISCHEN TRANSFORMATORS**
CONTROL CIRCUIT AND METHOD FOR CONTROLLING A PIEZOELECTRIC TRANSFORMER
CIRCUIT DE COMMANDE ET PROCÉDÉ DE COMMANDE D'UN TRANSFORMATEUR PIÉZOÉLECTRIQUE

(30) Priorität: 12.11.2015 DE 102015119574
(43) Veröffentlichungstag der Anmeldung: 05.08.2020
(62) Teilanmeldung aus: 16797502.8
(73) Patentinhaber: TDK Electronics AG, 81671 München (DE)
(72) Erfinder: Weilguni, Michael, 4232 Hagenberg (AT)
(74) Vertreter: Epping - Hermann - Fischer

(56) Entgegenhaltungen:
- JP-B2- 3 037 903
- US-A- 5 866 968
- US-A- 6 016 052
- US-A1- 2004 095 020
- US-B2- 8 639 133

## Beschreibung

Die vorliegende Erfindung betrifft eine Ansteuerschaltung für einen piezoelektrischen Transformator. Die Aufgabe der Ansteuerschaltung ist es, einen piezoelektrischen Transformator hinsichtlich der Frequenz so anzusteuern beziehungsweise zu regeln, dass dieser zuverlässig ein Plasma zünden kann. Um eine Plasmazündung zu ermöglichen, sollte der piezoelektrische Transformator mit einer Frequenz angesteuert werden, die zumindest in der Nähe seiner Resonanzfrequenz liegt. Da die Resonanzfrequenz von vielen Parametern abhängig ist, beispielsweise der Leistung des vom piezoelektrischen Transformator erzeugten Plasmas, den Fertigungstoleranzen, dem verwendeten Prozessgas und der Umgebungstemperatur, ist eine Rückkopplung erforderlich, anhand der die Ansteuerschaltung die Frequenz ständig anpassen kann.

US 5,923,542 A beschreibt eine Ansteuerschaltung für einen piezoelektrischen Transformator. Hier wird die Ausgangsspannung beziehungsweise der Ausgangsstrom des piezoelektrischen Transformators als Signal zur Rückkopplung verwendet. Soll jedoch der piezoelektrische Transformator in einem Plasmagenerator verwendet werden, ist es nicht möglich, Signale von der Ausgangsseite wie die Ausgangsspannung oder den Ausgangsstrom zur Rückkopplung zu verwenden, da an der Ausgangsseite des piezoelektrischen Transformators das Plasma gezündet werden soll.

Aus US 8,710,761 B2 und DE 102013103159 A1 sind jeweils Ansteuerschaltungen bekannt, die ein Rückkopplungssignal auf der Eingangsseite eines piezoelektrischen Transformators gewinnen. Diese verwenden die Phasenlage zwischen der Eingangsspannung und dem Eingangsstrom als Rückkopplungssignal, auf dessen Basis die Ansteuerfrequenz angepasst wird. Die Messung der Phase ist mit einem nicht unerheblichen technischen Aufwand verbunden und erfordert daher eine aufwändige Messschaltung.

Das Dokument US6016052 offenbart in Abb. 17 eine Ansteuerschaltung mit einem piezoelektrischem Transformator (1702), einer Induktivität (L2) und einer Steuereinheit (1710), die die Ansteuerungsfrequenz in Abhängigkeit einer mittleren Stromstärke bezüglich der Induktivität anpasst.

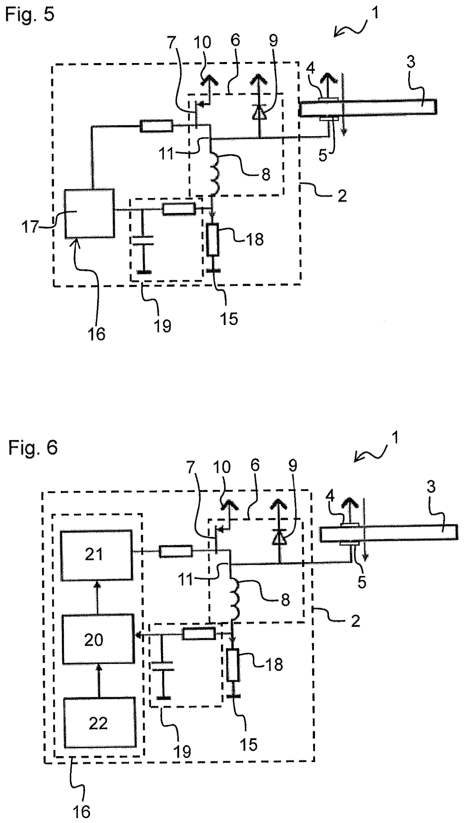

Das Dokument US8639133 zeigt eine Schaltung zur Ansteuerung von einem piezoelektrischen Energieumwandler (10)(vgl. Abb. 5 und 6).

Das Dokument US2004095020 offenbart in den Abb. 1 und 25 ein Kontrollsystem zur simultanen Regulierung von piezoelektrischen Energieumwandler.

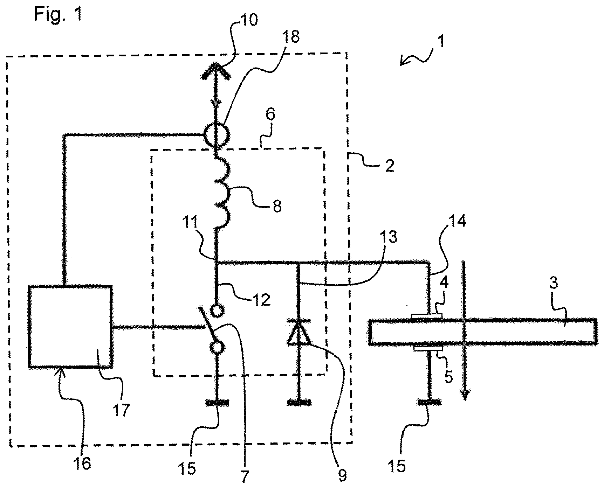

Das Dokument JP3037903B zeigt insbesondere eine Regelung mittels Erfassung des Spitzenstroms durch die Spule (siehe Abb. 1).

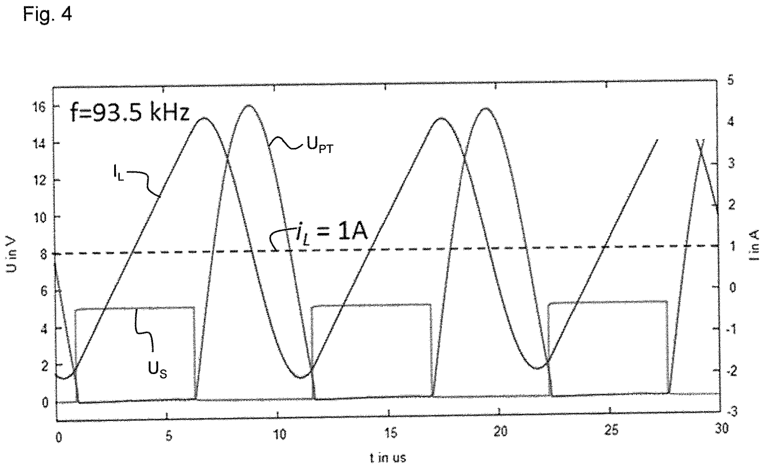

Das Dokument US5866968 offenbart ähnliche Schaltpläne zur Kontrolle von einem piezoelektrischem Energieumwandler(siehe Abb. 4).

Aufgabe der vorliegenden Erfindung ist es daher, eine verbesserte Ansteuerschaltung sowie ein verbessertes Verfahren zur Ansteuerung eines piezoelektrischen Transformators anzugeben.

Diese Aufgabe wird durch eine Ansteuerschaltung gemäß dem vorliegenden Anspruch 1 sowie durch ein Verfahren zur Ansteuerung eines piezoelektrischen Transformators gemäß dem zweiten unabhängigen Anspruch gelöst.

Es wird eine Ansteuerschaltung vorgeschlagen, die dazu ausgestaltet ist, an einen piezoelektrischen Transformator eine Spannung mit einem periodischen Verlauf anzulegen, deren Periodendauer durch eine Ansteuerfrequenz festgelegt ist, wobei die Ansteuerschaltung eine Induktivität und eine Steuereinheit aufweist und wobei die Steuereinheit dazu ausgestaltet ist, die Ansteuerfrequenz der angelegten Spannung in Abhängigkeit von einer mittleren Stromstärke eines durch die Induktivität fließenden Stroms anzupassen.

Dementsprechend soll die mittlere Stromstärke des durch die Induktivität fließenden Stroms als Parameter für das Rückkopplungssignal verwendet werden, auf dessen Basis die Ansteuerschaltung die Ansteuerfrequenz, mit der der piezoelektrische Transformator betrieben wird, anpasst. Die Verwendung des mittleren Stroms weist zahlreiche Vorteile auf. Zum einen kann der mittlere Strom mit einer geringen Anzahl von Bauelementen überwacht werden. Es kann beispielsweise ein Shunt-Widerstand, ein Stromtransformator oder ein Hall-Sensor zur Messung des mittleren Stroms verwendet werden. Dementsprechend weist die Ansteuerschaltung eine sehr geringe Anzahl von Bauelementen auf. Durch die geringe Anzahl an Bauteilen wird der für die Ansteuerschaltung benötigte Raum reduziert. Dementsprechend eignet sich die Ansteuerschaltung insbesondere für Anwendungen mit begrenztem Raum, beispielsweise in einem als Handgerät einsetzbaren Plasmagenerator.

Bei dem piezoelektrischen Transformator kann es sich um einen Rosen-Typ-Transformator handeln. Der piezoelektrische Transformator kann zur Erzeugung eines nicht-thermischen Atmosphärendruck-Plasmas geeignet sein.

Die Steuereinheit kann dazu ausgestaltet sein, die Ansteuerfrequenz festzulegen und anzupassen, mit welcher die Ansteuerschaltung ein periodisches Spannungssignal an den piezoelektrischen Transformator anlegt. Beispielsweise kann die Steuereinheit einen Schalter mit einer Frequenz betätigen, wobei die Frequenz, mit der der Schalter betätigt wird, die Ansteuerfrequenz festlegt.

Die Ansteuerschaltung kann einen Klasse-E Verstärker aufweisen, der die Induktivität aufweist. Darüber hinaus kann der Klasse-E Verstärker weitere Bauteile wie beispielsweise den Schalter aufweisen.

Ein Klasse-E Verstärker ist ein Verstärker, bei dem eine Schaltstufe auf einem Schwingkreis arbeitet, dessen Spannung über einen Tiefpass zur Last gelangt. Die Schaltstufe schließt immer dann, wenn der Schwingkreis im Nulldurchgang angelangt ist. Bei dem Schwingkreis kann es sich um einen LC-Schwingkreis handeln, der ein induktives Element und ein kapazitives Element aufweist. In der vorliegenden Ansteuerschaltung kann der Klasse-E Verstärker eine Induktivität aufweisen, die das induktive Element des Schwingkreises ausbildet. Das kapazitive Element des Schwingkreises kann durch die Kapazität des piezoelektrischen Transformators gebildet werden, mit dem der Klasse-E Verstärker verschaltet ist. Bei der oben genannten Schaltstufe kann es sich um den Schalter des Klasse-E Verstärkers handeln.

Die Ansteuerfrequenz kann derart eingestellt werden, dass sie zwischen einer Resonanzfrequenz und einer Antiresonanzfrequenz des piezoelektrischen Transformators liegt. Auf diese Weise kann es ermöglicht werden, dass die Ansteuerschaltung den Schalter stets dann betätigt, wenn an dem piezoelektrischen Transformator keine Spannung anliegt. Dieses wird als Zero Voltage Switching bezeichnet. Durch Zero Voltage Switching können die Verluste reduziert werden.

Die Resonanzfrequenz und die Antiresonanzfrequenz des piezoelektrischen Transformators hängen von der aktuell von dem piezoelektrischen Transformator erzeugten Plasmaleistung ab. Die Ansteuerfrequenz kann daher ständig derart angepasst werden, dass sie stets zwischen der Antiresonanzfrequenz und der Resonanzfrequenz liegt. Dabei kann für den Betrieb des Transformators eine Ansteuerfrequenz gewählt werden, die näher an der Resonanzfrequenz als an der Antiresonanzfrequenz liegt. Unmittelbar nach dem Einschalten des Transformators kann dieser zunächst mit einer Ansteuerfrequenz angesteuert werden, die näher an der Antiresonanzfrequenz als an der Resonanzfrequenz liegt. Insbesondere steigt die Leistung des von dem Transformator erzeugten Plasmas, wenn die Frequenz, mit der der Transformator betrieben wird, in Richtung der Resonanzfrequenz verringert wird. In bestimmten Anwendungen kann auch eine Ansteuerfrequenz gewählt werden, die nicht näher bei der Resonanzfrequenz als bei der Antiresonanzfrequenz liegt, beispielsweise um eine geringe Plasmaleistung einzustellen.

Die Steuereinheit kann dazu ausgestaltet sein, die Ansteuerfrequenz zu erhöhen, wenn die mittlere Stromstärke einen ersten vorbestimmten Grenzwert überschreitet, wobei die Steuereinheit dazu ausgestaltet ist, die Ansteuerfrequenz zu verringern, wenn die mittlere Stromstärke einen zweiten vorbestimmten Grenzwert unterschreitet. Auf diese Weise kann sichergestellt werden, dass die mittlere Stromstärke stets zwischen dem ersten und dem zweiten Grenzwert gehalten wird. Damit ergibt sich ein stabiles Verhalten des durch die Ansteuerschaltung betriebenen piezoelektrischen Transformators.

Die Steuereinheit ist primär dazu ausgestaltet, die Ansteuerfrequenz zu erhöhen, wenn die mittlere Stromstärke einen vorbestimmten Zielwert überschreitet und die Ansteuerfrequenz zu verringern, wenn die mittlere Stromstärke den vorbestimmten Zielwert unterschreitet. Dementsprechend versucht die Ansteuerschaltung ständig, die mittlere Stromstärke auf den vorbestimmten Zielwert einzuregeln. Auch dieses führt zu einem stabilen Verhalten des piezoelektrischen Transformators.

Die angelegte Spannung kann einen halbsinusförmigen oder einen sinusförmigen Verlauf aufweisen. Der sinusförmige Verlauf kann beispielsweise durch eine Ansteuerschaltung realisiert werden, bei der zwei Klasse-E Verstärker gegenläufig zueinander geschaltet werden.

Die Ansteuerschaltung kann ferner eine Messeinheit zur Messung des mittleren Stroms über die Induktivität aufweisen, die in Reihe mit der Induktivität geschaltet ist. Die Messeinheit kann beispielsweise einen Shunt-Widerstand, einen Hall-Sensor oder einen Stromtransformator aufweisen. Dementsprechend kann mit einfachen Bauelementen eine Messung des mittleren Stroms vorgenommen werden, sodass insgesamt wenige Bauteile zur Realisierung der Schaltung erforderlich sind. Dadurch wird der Platzbedarf für die Ansteuerschaltung reduziert und die Verwendung in Handgeräten ermöglicht.

Die Messeinheit zur Messung der mittleren Stromstärke sollte den Strom in Abständen messen, die wesentlich größer als die Periodendauer des periodischen Signals sind. Beispielsweise sollte die Messeinheit die mittlere Stromstärke in periodischen Abständen messen die mindestens zehnmal länger sind als die Periodendauer des periodischen Signals, das an den piezoelektrischen Transformator angelegt wird.

Dadurch wird es ermöglicht, die Stromstärke über eine gewisse Messzeit zu integrieren und so die mittlere Stromstärke zu bestimmen. Jeweils nach einer Messung der mittleren Stromstärke kann anschließend die Ansteuerfrequenz angepasst werden, sofern dieses nötig erscheint.

Die Steuereinheit kann einen Mikrocontroller oder einen Voltage Controlled Oscillator aufweisen. Beide ermöglichen eine Anpassung der Frequenz, mit der ein Schalter betätigt wird.

Die Ansteuerschaltung kann einen Schalter aufweisen, wobei die Steuereinheit dazu ausgestaltet ist, den Schalter periodisch zu betätigen, wobei die Ansteuerfrequenz durch die Periodendauer der Betätigung des Schalters festgelegt wird. Als Periodendauer wird hierbei die Zeit bezeichnet, welche zwischen zwei Einschaltvorgängen des Schalters vergeht. Bei dem Betätigen des Schalters kann es sich um ein Öffnen oder Schließen des Schalters handeln. Bei dem Schalter kann es sich um einen Schalttransistor, insbesondere einen MOSFET, handeln.

Ein weiterer Aspekt der vorliegenden Erfindung betrifft einen Plasmagenerator, der die oben beschriebene Ansteuerschaltung und einen piezoelektrischen Transformator aufweist. Der piezoelektrische Transformator weist zwei Außenelektroden auf, wobei die Ansteuerschaltung dazu ausgestaltet ist, die Spannung zwischen den Außenelektroden des piezoelektrischen Transformators anzulegen. Der Plasmagenerator ist zur Erzeugung eines nicht-thermischen Atmosphärendruck-Plasmas ausgelegt.

Ein weiterer Aspekt der vorliegenden Erfindung betrifft ein Verfahren zur Ansteuerung eines piezoelektrischen Transformators, wobei der piezoelektrische Transformator mit einer Ansteuerschaltung verbunden ist, die dazu ausgestaltet ist, an den piezoelektrischen Transformator eine Spannung anzulegen und die eine Induktivität aufweist. Bei der Ansteuerschaltung kann es sich insbesondere um die oben beschriebene Ansteuerschaltung handeln. Dementsprechend kann jedes funktionale oder strukturelle Merkmal, das im Zusammenhang mit der Ansteuerschaltung offenbart wurde, auch auf das Verfahren zutreffen.

Das Verfahren weist die folgenden Schritte auf:
- Anlegen einer Spannung mit einem periodischen Verlauf, deren Periodendauer durch eine Ansteuerfrequenz festgelegt ist, an den piezoelektrischen Transformator,
- Messen einer mittleren Stromstärke eines durch die Induktivität fließenden Stroms, und
- Regeln der Ansteuerfrequenz in Abhängigkeit von der gemessenen mittleren Stromstärke.

Da die mittlere Stromstärke über die Induktivität unmittelbar mit der Stromstärke eines Eingangsstroms an dem piezoelektrischen Transformator zusammenhängt, kann über diese Größe unmittelbar auf die von dem piezoelektrischen Transformator erzeugte Plasmaleistung geschlossen werden. Wie oben bereits erläutert wurde, ermöglicht es dieses Verfahren ferner, eine Ansteuerschaltung mit einer geringen Anzahl von Bauelementen zu verwenden, sodass sich dieses Verfahren insbesondere für Handgeräte eignet.

In dem Schritt Anlegen einer periodischen Spannung kann zunächst eine Spannung mit einer Ansteuerfrequenz an dem piezoelektrischen Transformator angelegt werden, die unter einer Antiresonanzfrequenz des piezoelektrischen Transformators liegt, wobei die Ansteuerfrequenz schrittweise reduziert wird. Überschreitet die mittlere Stromstärke eines durch die Induktivität fließenden Stroms einen vorbestimmten Grenzwert, ist der Schritt des schrittweisen Reduzierens der Ansteuerfrequenz abgeschlossen. Es kann dementsprechend mit einer Ansteuerfrequenz unterhalb, aber nahe der Antiresonanzfrequenz gestartet werden, was einer zunächst hohen Impedanz des piezoelektrischen Transformators entspricht. Nun werden schrittweise die Ansteuerfrequenz und damit die Impedanz des Transformators reduziert, bis sich eine gewünschte Plasmaleistung einstellt. Anschließend ist eine Feinnachregelung erforderlich.

Hierfür kann bei dem Schritt des Regelns der Ansteuerfrequenz die Ansteuerfrequenz erhöht werden, wenn die mittlere Stromstärke einen ersten vorbestimmten Grenzwert überschreitet und die Ansteuerfrequenz verringert werden, wenn die mittlere Stromstärke einen zweiten vorbestimmten Grenzwert unterschreitet.

Im Folgenden wird die vorliegende Erfindung anhand der beigefügten Figuren näher beschrieben.
- Figur 1: zeigt ein Prinzipschaltbild eines Plasmagenerators, der eine Ansteuerschaltung und einen piezoelektrischen Transformator aufweist,
- Figur 2: zeigt den Verlauf der Impedanz des piezoelektrischen Transformators für verschiedene Plasmaleistungen,
- Figur 3 und Figur 4: zeigen jeweils den zeitlichen Verlauf einer an einem Schalter anliegenden Spannung, der Stromstärke über eine Induktivität und der Spannung an dem piezoelektrischen Transformator für verschiedene Frequenzen und daher verschiedene Werte der mittleren Stromstärke,
- Figur 5: zeigt einen Plasmagenerator mit einer Ansteuerschaltung gemäß einem ersten Ausführungsbeispiel,
- Figur 6: zeigt einen Plasmagenerator mit einer Ansteuerschaltung gemäß einem zweiten Ausführungsbeispiel,
- Figur 7: zeigt einen Plasmagenerator mit einer Ansteuerschaltung gemäß einem dritten Ausführungsbeispiel.

Figur 1 zeigt ein Prinzipschaltbild eines Plasmagenerators 1. Der Plasmagenerator 1 weist eine Ansteuerschaltung 2 und einen piezoelektrischen Transformator 3 auf. Die Ansteuerschaltung 2 ist mit einem piezoelektrischen Transformator 3 verschaltet und ermöglicht es, an diesen eine Spannung anzulegen.

Bei dem piezoelektrischen Transformator 3 handelt es sich beispielsweise um einen Rosen-Typ Transformator. Der piezoelektrische Transformator 3 ist zur Erzeugung von nichtthermischem Atmosphärendruck-Plasma geeignet. Der piezoelektrische Transformator 3 weist einen Eingangsbereich und einen Ausgangsbereich auf. Der piezoelektrische Transformator 3 weist eine erste Außenelektrode 4 und eine zweite Außenelektrode 5 auf, die jeweils in dem Eingangsbereich mit Innenelektroden verschaltet sind. Die Ansteuerschaltung 2 ist dazu ausgestaltet, eine Spannung zwischen den beiden Außenelektroden 4, 5 des piezoelektrischen Transformators 3 anzulegen.

Wird in dem Eingangsbereich des Transformators 3 eine periodische Spannung angelegt, deren Ansteuerfrequenz hinreichend nahe an einer Resonanzfrequenz des piezoelektrischen Transformators 3 liegt, so entsteht in dem Ausgangsbereich des piezoelektrischen Transformators 3 eine Hochspannung, die ein Prozessgas ionisieren kann, wodurch ein Plasma erzeugt werden kann.

Die Ansteuerschaltung 2 weist einen Klasse-E Verstärker 6 auf. Der Klasse-E Verstärker 6 weist einen Schalter 7 und eine Induktivität 8 auf. Bei dem Schalter 7 handelt es sich um einen Schalttransistor, beispielsweise einen MOSFET. Ferner weist der Klasse-E Verstärker 6 eine Diode 9 auf.

Ferner weist die Ansteuerschaltung 2 eine Spannungsquelle 10 auf, die eine Gleichspannung liefert. Die Spannungsquelle 10 ist mit der Induktivität 8 verschaltet. Bei der Spannungsquelle 10 kann es sich beispielsweise um eine Batterie handeln.

Die Induktivität 8 ist in Reihe mit einem Knotenpunkt 11 der Ansteuerschaltung 2 verschaltet, wobei der Knotenpunkt 11 in Reihe mit weiteren Pfaden 12, 13, 14 der Ansteuerschaltung 2 verschaltet ist. Dabei ist in einem Pfad 12 der Schalter 7 angeordnet. Über den Schalter 7 kann der Knotenpunkt 11 mit einem Referenzpotential 15 verbunden werden. Bei dem Referenzpotential 15 kann es sich um ein Massepotential handeln. Ist der Schalter 7 geschlossen, so liegt an dem Knotenpunkt 11 das Referenzpotential 15 an.

Ist der Schalter 7 geschlossen, so fließt ein Strom von der Spannungsquelle 10 über die Induktivität 8 und den Schalter 7 zu dem Referenzpotential 15. Dabei wird in der Induktivität 8 ein magnetisches Feld aufgebaut und auf diese Weise Energie gespeichert. Ist der Schalter 7 geöffnet, kann kein Strom über den Schalter 7 fließen.

Ein weiterer mit dem Knotenpunkt 11 verschalteter Pfad 13 weist die Diode 9 auf. Der weitere Pfad 13 verbindet den Knotenpunkt 11 über die Diode 9 mit dem Referenzpotential 15. Die Diode 9 dient hierbei als Schutzdiode. Insbesondere dient die Diode 9 zum Schutz des Schalters 7. Insbesondere schützt die Diode 9 den Schalter 7 vor Beschädigungen in dem Fall, dass der Schalter 7 betätigt wird, wenn der piezoelektrische Transformator 3 eine große negative Spannung zwischen der ersten Außenelektrode 4 und der zweiten Außenelektrode 5 generiert, z.B. beim Einschalten. In diesem Fall kann ein Zero Voltage Switching noch nicht erreicht werden.

Ein dritter mit dem Knotenpunkt 11 verschalteter Pfad 14 ist mit der ersten Außenelektrode 4 des piezoelektrischen Transformators 3 verbunden. Die zweite Außenelektrode 5 des piezoelektrischen Transformators 3 ist mit dem Referenzpotential 15 verbunden.

Ist der Schalter 7 geschlossen, so liegt an der ersten Außenelektrode 4 das Referenzpotential 15 an. Dementsprechend liegt keine Spannung zwischen den beiden Außenelektroden 4, 5 des piezoelektrischen Transformators 3 an.

Wird der Schalter 7 geöffnet, so fließt kein Strom mehr über den Schalter 7. Dementsprechend wird das magnetische Feld der Induktivität 8 abgebaut. Der in der Induktivität 8 gespeicherte Strom fließt weiter über den dritten Pfad 14 zur ersten Außenelektrode 4 des piezoelektrischen Transformators 3. Dadurch wird zwischen der ersten Außenelektrode 4 und der zweiten Außenelektrode 5 eine Spannung aufgebaut.

Die Ansteuerschaltung 2 weist ferner eine Steuereinheit 16 auf. Die Steuereinheit 16 weist einen Mikrocontroller 17 auf, der mit dem Schalter 7 verbunden ist. Der Mikrocontroller 17 ist dazu ausgestaltet, den Schalter 7 zu betätigen, d.h. den Schalter 7 zu öffnen und zu schließen. Der Mikrocontroller 17 kann den Schalter 7 in periodischen Abständen betätigen, wobei durch die Frequenz, mit der der Schalter 7 betätigt wird, eine Ansteuerfrequenz festgelegt wird. Die Ansteuerfrequenz entspricht der Frequenz der periodischen Spannung, die von der Ansteuerschaltung 2 an den piezoelektrischen Transformator 3 angelegt wird.

Des Weiteren weist die Ansteuerschaltung 2 eine Messeinheit 18 zur Messung des mittleren Stroms über die Induktivität 8 auf. Die Messeinheit 18 ist in dem in Figur 1 gezeigten Prinzipschaltbild seriell zwischen der Spannungsquelle 10 und der Induktivität 8 verschaltet. Alternativ könnte die Messeinheit 18 beispielsweise auch zwischen der Induktivität 8 und dem Knotenpunkt 11 angeordnet sein.

Bei der Messeinheit 18 handelt es sich hier um einen Stromtransformator. Die Messeinheit 18 ist mit der Steuereinheit 16 verbunden. Über die Messeinheit 18 wird ein Rückkopplungssignal an die Steuereinheit 16 weitergeleitet, das die mittlere Stromstärke des Stroms über die Induktivität 8 angibt. In Abhängigkeit von der mittleren Stromstärke kann die Steuereinheit 16 dann die Ansteuerfrequenz des Schalters 7 einstellen.

Alternativ kann die Messeinheit 18 Strom bestimmen, der momentan über die Induktivität 8 fließt, und ein entsprechendes Signal an die Steuereinheit 16 weitergeben. Die Steuereinheit 16 kann daraus die mittlere Stromstärke bestimmen, beispielsweise indem diese in einem Mikrocontroller berechnet wird.

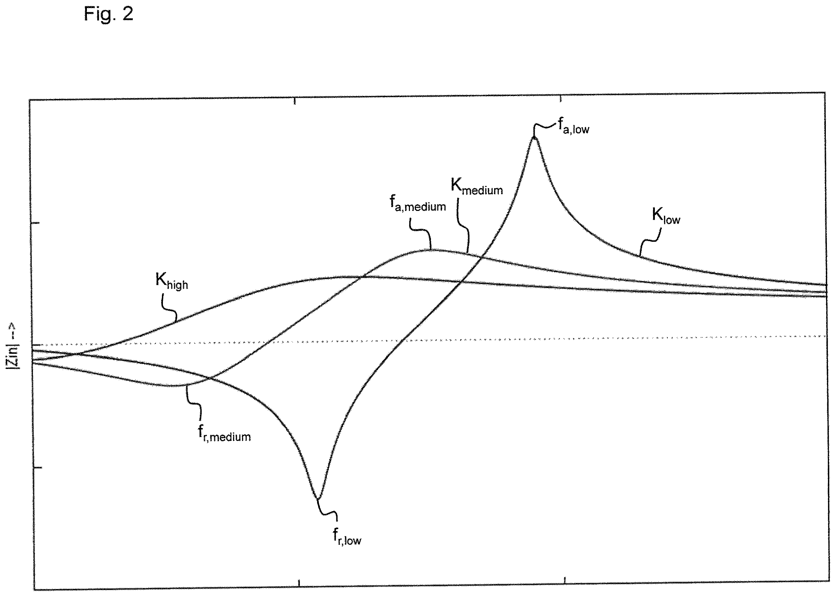

Figur 2 zeigt das Impedanzverhalten des piezoelektrischen Transformators 3. Dabei ist auf der Abszissenachse die Frequenz einer an den piezoelektrischen Transformator 3 angelegten, periodischen Spannung aufgetragen. Auf der Ordinatenachse ist der Betrag der Eingangsimpedanz aufgetragen.

In Figur 2 ist zu erkennen, dass das Impedanzverhalten von der vom piezoelektrischen Transformator 3 erzeugten Plasmaleistung abhängig ist. Die Kurve K_{low} beschreibt das Impedanzverhalten des piezoelektrischen Transformators 3 für den Fall, dass an der Ausgangsseite des piezoelektrischen Transformators 3 Plasma mit einer geringen Leistung erzeugt wird. In der Kurve K_{low} sind eine deutlich ausgeprägte Resonanzfrequenz f_{r,low}, bei der die Impedanz ein Minimum aufweist, und eine deutlich ausgeprägte Antiresonanzfrequenz f_{a,low}, bei der die Impedanz ein Maximum aufweist, zu erkennen.

Ferner beschreibt die Kurve K_{medium} das Impedanzverhalten für den Fall, dass an der Ausgangsseite des piezoelektrischen Transformators 3 Plasma mit einer mittleren Leistung erzeugt wird, wobei die Angaben mittlere und geringe Leistung insbesondere relativ zueinander zu verstehen sind. In der Kurve K_{medium} ist zu erkennen, dass das Impedanzverhalten des Transformators 3 bei mittlerer Leistung gegenüber dem Impedanzverhalten bei geringere Leistung abgeflacht ist. Das Minimum der Impedanz bei der Resonanzfrequenz f_{r,medium} für mittlere Plasmaleistung weist einen höheren Wert des Betrags der Eingangsimpedanz auf als das Minimum der Impedanz bei der Resonanzfrequenz f_{r,low} für geringe Plasmaleistung. Ferner weist das Maximum der Impedanz bei der Antiresonanzfrequenz f_{a,medium} für eine mittlere Plasmaleistung einen geringeren Betrag der Eingangsimpedanz auf als das Maximum der Impedanz bei der Antiresonanzfrequenz f_{a,low} für geringe Plasmaleistung.

Ferner sinken die Resonanzfrequenz und die Antiresonanzfrequenz mit steigender Plasmaleistung. So ist in Figur 2 zu erkennen, dass die Resonanzfrequenz f_{r,medium} für mittlere Plasmaleistung niedriger ist als die Resonanzfrequenz f_{r,low} für niedrige Plasmaleistung und dass die Antiresonanzfrequenz f_{a,medium} für mittlere Plasmaleistung niedriger ist als die Antiresonanzfrequenz f_{a,low} für niedrige Plasmaleistung.

Die Kurve K_{high} zeigt das Impedanzverhalten für den Fall, dass an der Ausgangsseite des piezoelektrischen Transformators 3 Plasma mit einer hohen Leistung erzeugt wird, wobei die Angabe hohe Leistung insbesondere relativ in Bezug auf die vorher genannte mittlere bzw. geringe Leistung zu verstehen ist. An der Kurve K_{high} ist zu erkennen, dass mit steigender Plasmaleistung die Resonanzfrequenz und die Antiresonanzfrequenz des piezoelektrischen Transformators 3 sinken und dass das Impedanzverhalten weiter abflacht.

Die Plasmaleistung des piezoelektrischen Transformators 3 hängt insbesondere von der Eingangsleistung ab. Liegt ein Strom mit einer höheren Stromstärke an dem piezoelektrischen Transformator 3 an, so erhöht sich die Plasmaleistung. Umgekehrt führt ein Absenken der Stromstärke des anliegenden Stroms zu einer geringeren Plasmaleistung.

Im Folgenden wird beschrieben, dass die Ansteuerschaltung 2 die Abhängigkeit des Impedanzverhaltens des piezoelektrischen Transformators 3 von der Plasmaleistung nutzt, um ein selbst-stabiles Verhalten des Plasmagenerators 1 herbeizuführen, bei dem die Verschiebung von Resonanz- und Antiresonanzfrequenz zu einer stabilen Regelung des piezoelektrischen Transformators 3 beitragen.

Dazu wird das Verfahren beschrieben, mit dem die Ansteuerschaltung 2 den piezoelektrischen Transformator 3 betreibt. Nach dem Anschalten des Plasmagenerators 1 wird von der Steuereinheit 16 der Schalter 7 zunächst mit einer Frequenz betätigt, die unterhalb, aber in der Nähe der Antiresonanzfrequenz des piezoelektrischen Transformators 3 liegt. Es wird dabei von der Antiresonanzfrequenz ausgegangen, die der piezoelektrische Transformator 3 aufweist, wenn kein Plasma erzeugt wird.

Da die Ansteuerfrequenz nahe bei der Antiresonanzfrequenz liegt, weist der piezoelektrische Transformator 3 hier eine hohe Impedanz auf, so dass zunächst kein Plasma erzeugt wird.

Im nächsten Verfahrensschritt wird nun die Ansteuerfrequenz der Ansteuerschaltung 2 schrittweise in Richtung der Resonanzfrequenz verringert. Dabei nimmt die Impedanz der piezoelektrischen Transformators 3 mit jeder Verringerung der Ansteuerfrequenz ebenfalls ab. Da die Impedanz sinkt und die Eingangsspannung an dem piezoelektrischen Transformator 3 konstant bleibt, nimmt der Eingangsstrom zu. Dadurch steigt die Eingangsleistung. Überschreitet die Eingangsleistung einen bestimmten Wert, wird an der Ausgangsseite des piezoelektrischen Transformators 3 ein Plasma gezündet.

Mit dem Absenken der Ansteuerfrequenz und dem damit verbundenen Ansteigen der Plasmaleistung ist auch eine Verschiebung der Impedanzkurve verbunden, wie bereits im Zusammenhang mit Figur 2 erläutert wurde. Insbesondere verschiebt sich die Resonanzfrequenz hin zu einer kleineren Frequenz. Damit wird sichergestellt, dass bei hinreichend kleiner Schrittweite der Schritte, in denen die Ansteuerfrequenz reduziert wird, die Ansteuerfrequenz nicht unter die Resonanzfrequenz fällt.

Ferner wird mittels der Messeinheit 18 zur Messung des mittleren Stroms über die Induktivität 8 ständig die mittlere Stromstärke dieses Stroms überwacht. Während die Ansteuerfrequenz schrittweise reduziert wird, nimmt die mittlere Stromstärke zu, da die Impedanz des piezoelektrischen Transformators 3 abnimmt. Übersteigt nun die mittlere Stromstärke einen ersten vorbestimmten Grenzwert, wird die Ansteuerfrequenz erhöht. Ferner kann ein zweiter vorbestimmter Grenzwert definiert sein, der geringer ist als der erste vorbestimmte Grenzwert. Wenn die mittlere Stromstärke kleiner ist als der zweite vorbestimmte Grenzwert, so wird die Ansteuerfrequenz reduziert.

Auf diese Weise kann sichergestellt werden, dass die Ansteuerfrequenz stets derart geregelt wird, dass die mittlere Stromstärke des Stroms über die Induktivität 8 zwischen dem ersten und dem zweiten vorbestimmten Grenzwert liegt. Dadurch kann die Plasmaleistung des piezoelektrischen Transformators 3 auf ein nahezu konstantes Verhalten eingeregelt werden.

Ferner ermöglicht es dieses Verfahren die oben beschriebene Abflachung der Impedanzkurve bei steigender Plasmaleistung zu nutzen, um ein selbst-stabiles Verhalten des Plasmagenerators 1 herbeizuführen. Wird die Plasmaleistung zu groß, nimmt mit steigender Plasmaleistung die Impedanz nahe der Resonanzfrequenz zu. Dadurch wird die Plasmaleistung nach oben begrenzt.

In einer alternativen Ausgestaltung des Verfahrens wird statt dem ersten und dem zweiten vorbestimmten Grenzwert nur ein einziger vorbestimmter Zielwert definiert. Überschreitet die mittlere Stromstärke den vorbestimmten Zielwert, wird die Ansteuerfrequenz erhöht. Unterschreitet die mittlere Stromstärke den vorbestimmten Zielwert, wird die Ansteuerfrequenz reduziert. Auf diese Weise kann stets ein nahezu konstanter mittlerer Strom eingeregelt werden, was wiederum zu einer nahezu konstanten Plasmaleistung des piezoelektrischen Transformators 3 führt. Auch dieses alternative Verfahren nutzt die Abflachung der Impedanzkurve um ein selbst-stabiles Verhalten des piezoelektrischen Transformators 3 zu bewirken.

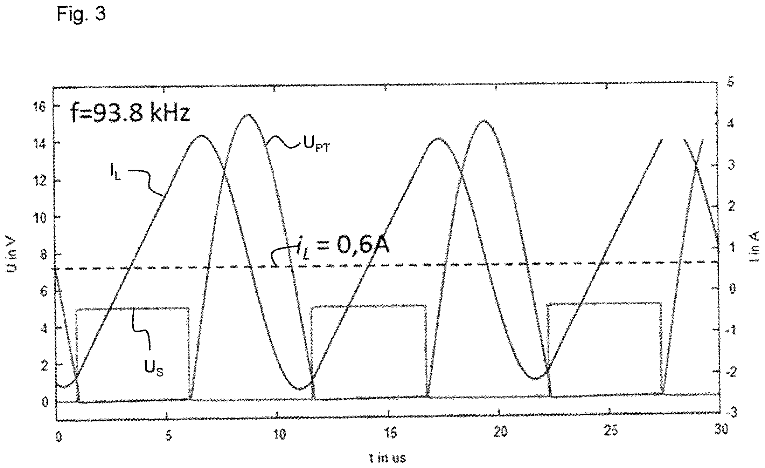

Das Verhalten der Ansteuerschaltung wird im Zusammenhang mit Figur 3 näher erläutert. Figur 3 zeigt den zeitlichen Verlauf der an dem Schalter 7 anliegenden Schaltspannung, der Stromstärke durch die Induktivität 8 und der Spannung am piezoelektrischen Transformator 3 jeweils für einen mittleren Strom von 0,6 A durch die Induktivität 8.

Insbesondere stellt die Kurve Us, den zeitlichen Verlauf der an dem Schalter 7 anliegenden Schaltspannung da. Dabei ist auf der Abszissenachse die Zeit in µs aufgetragen und auf der Ordinatenachse ist die Schaltspannung in V aufgetragen. Beträgt die Schaltspannung 0V, so ist der Schalter 7 geöffnet. Nimmt die Schaltspannung einen anderen Wert größer als 0V an, so ist der Schalter 7 geschlossen. In dem hier betrachteten Beispiel ist der Schalter 7 bei einer Schaltspannung von 5V geschlossen.

Figur 3 ist ferner zu entnehmen, dass der Schalter 7 in periodischen Abständen geöffnet und geschlossen wird. Die Frequenz, mit der der Schalter 7 betätigt wird, beträgt hier 93,8 kHz. Diese Frequenz bestimmt die Ansteuerfrequenz des piezoelektrischen Transformators 3.

Die Kurve I_{L} stellt den zeitlichen Verlauf der Stromstärke durch die Induktivität 8 dar. Auf der Abszissenachse ist wieder die Zeit in µs aufgetragen und auf der Ordinatenachse ist die Stromstärke des Stroms durch die Induktivität 8 in A aufgetragen.

Wird der Schalter 7 geschlossen, so fließt ein Strom von der Spannungsquelle 10 durch die Induktivität 8 zu dem Referenzpotential 15. Die Stromstärke dieses Stroms nimmt annähernd linear zu, bis der Schalter 7 geöffnet wird. Das von der Induktivität 8 erzeugte Magnetfeld wird abgebaut, indem der Strom über den piezoelektrischen Transformator 3 weiterfließt. Die Stromstärke dieses Stroms nimmt nahezu linear ab, bis der Schalter 7 wieder geöffnet wird.

In Figur 3 ist ferner die Linie i_{L} eingezeichnet, die den Mittelwert der Stromstärke markiert. Dieser beträgt hier 0,6 A. Die Ansteuerfrequenz des Schalters 7 wird stets so nachgeregelt, dass sich der Mittelwert auf diesen Wert einstellt.

Die Kurve U_{PT} stellt den zeitlichen Verlauf der an dem piezoelektrischen Transformator 3 anliegenden Spannung dar. Auf der Abszissenachse ist wieder die Zeit in µs aufgetragen und auf der Ordinatenachse ist die Spannung in V aufgetragen.

Ist der Schalter 7 geschlossen, so liegt an dem piezoelektrischen Transformator 3 keine Spannung an. Beide Außenelektroden 4, 5 sind mit dem Referenzpotential 15 verbunden. Wird nun der Schalter 7 geöffnet, so wird durch den Strom, der von der Induktivität 8 zu dem piezoelektrischen Transformator 3 fließt eine Spannung zwischen den beiden Außenelektroden 4, 5 aufgebaut. Insgesamt ergibt sich ein halbsinusförmiger Verlauf der Spannung an dem piezoelektrischen Transformator 3. Der halbsinusförmige Verlauf weist eine Frequenz auf, die der Frequenz entspricht, mit der der Schalter 7 betätigt wird. Diese Frequenz wird als Ansteuerfrequenz bezeichnet. Der halbsinusförmige Verlauf ergibt sich aus einem resonanten Verhalten einer Eingangskapazität des piezoelektrischen Transformators 3 zusammen mit der Induktivität 8 sowie einem in dem piezoelektrischen Transformator 3 selbst ausgebildeten Schwingkreis.

Durch eine geeignete Wahl der Induktivität 8 und der Ansteuerfrequenz wird erreicht, dass die halbsinusförmige Spannung am piezoelektrischen Transformator 3 in dem Zeitpunkt zu null wird, wenn der Schalter 7 geschlossen wird. Das Schalten erfolgt somit, wenn an dem piezoelektrischen Transformator 3 keine Spannung anliegt. Diese Art von Schaltung wird auch als Zero Voltage Switching (ZVS) bezeichnet. ZVS ist für Ansteuerfrequenzen möglich, die zwischen der Resonanzfrequenz und der Antiresonanzfrequenz des piezoelektrischen Transformators 3 liegen.

Abhängig von der Ansteuerfrequenz ändert sich, wie im Zusammenhang mit Figur 2 erläutert, die Impedanz des piezoelektrischen Transformators 3. Auch die mittlere Stromstärke des Stroms durch die Induktivität 8 hängt mit der Ansteuerfrequenz zusammen. Figur 4 zeigt die in Figur 3 dargestellten Kurven U_{S}, I_{L}, U_{PT} bei einer Regelung der Ansteuerschaltung auf eine mittlere Stromstärke von 1A. Dieser ergibt sich aus einer geringeren Ansteuerfrequenz von 93,5 kHz.

Figur 5 zeigt das Schaltbild eines Plasmagenerators 1, der den piezoelektrischen Transformator 3 und eine Ansteuerschaltung 2 gemäß einem ersten Ausführungsbeispiel aufweist. Der Aufbau des Klasse-E Verstärkers 6 ist gegenüber dem in Figur 1 gezeigten Prinzipschaltbild gespiegelt. Die Spannungsquelle 10 ist nun unmittelbar mit dem Schalter 7 verbunden. Insbesondere ist die Spannungsquelle 10 mit der Source-Elektrode eines Schalttransistors verbunden, der als Schalter 7 eingesetzt wird. Bei dem Schalttransistor 7 handelt es sich um einen p-Kanal MOSFET.

Zur Messung der mittleren Stromstärke des über die Induktivität 8 fließenden Stroms wird hier eine Messeinheit 18 verwendet, die einen Shuntwiderstand aufweist, der in Reihe mit der Induktivität 8 geschaltet ist. Der Shuntwiderstand ist ferner mit dem Referenzpotential 15 verschaltet. Die Ansteuerschaltung 2 weist ferner einen RC-Tiefpass 19 auf, der mit dem Shuntwiderstand verbunden ist und der das Stromsignal filtern soll. Über den RC-Tiefpass 19 wird ein Signal an die Steuereinheit 16 gegeben, dessen Spannung proportional zur mittleren Stromstärke ist. Die Steuereinheit 16 weist einen Mikrocontroller 17 auf, der einen integrierten Analog-Digital-Wandler samt Referenzspannungsquelle aufweisen kann, um das Signal auszuwerten. Alternativ könnte die Steuereinheit 16 einen Komparator aufweisen, der das Spannungssignal mit einer externen Referenzspannung vergleicht.

Der p-Kanal MOSFET, der hier als Schalter 7 eingesetzt wird, kann durch die Steuereinheit 16 angesteuert werden. Je nach Versorgungsspannung kann ein Gate-Treiber zwischen der Steuereinheit und dem p-Kanal MOSFET erforderlich sein. Bei der in Figur 5 gezeigten Diode 9 kann es sich um eine integrierte Body Diode des MOSFET handeln. Alternativ kann es sich bei der Diode 9 um eine diskrete Diode handeln, die parallel zum MOSFET geschaltet ist.

Figur 6 zeigt das Schaltbild eines Plasmagenerators 1, der den piezoelektrischen Transformator 3 und eine Ansteuerschaltung 2 gemäß einem zweiten Ausführungsbeispiel aufweist.

Bei der Ansteuerschaltung 2 gemäß dem zweiten Ausführungsbeispiel weist die Steuereinheit 16 statt dem Mikrocontroller 17 einen Voltage Controlled Oscillator (VCO) 20 auf, welcher die Schaltfrequenz für den Schalter 7 vorgibt. Ferner weist die Ansteuerschaltung 2 einen PI-Regler (PI = Proportional-Integral) 21 auf, der die mittlere Stromstärke mit einem Referenzwert vergleicht und ein entsprechendes Signal an den Voltage Controlled Oscillator 20 weitergibt, über das die Frequenz des Voltage Controlled Oscillator 20 eingestellt wird. Der Referenzwert wird von eine Referenzspannungsquelle 22 bereitgestellt.

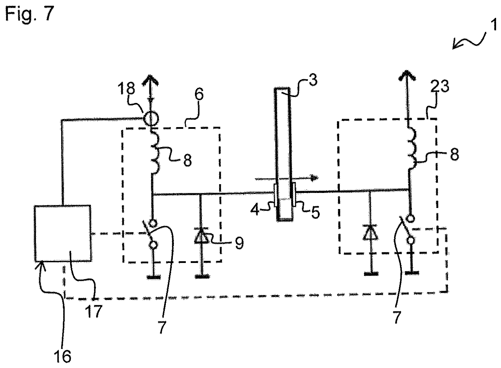

Figur 7 zeigt das Schaltbild eines Plasmagenerators 1, der den piezoelektrischen Transformator 3 und eine Ansteuerschaltung 2 gemäß einem dritten Ausführungsbeispiel aufweist.

Die Ansteuerschaltung gemäß dem dritten Ausführungsbeispiel weist einen zweiten Klasse-E Verstärker 23 auf. Der Klasse-E Verstärker 6 und der zweite Klasse-E Verstärker 23 bilden zusammen einen Push-Pull Verstärker. Der zweite Klasse-E Verstärker 23 weist einen Schalter 7 und eine Induktivität 8 auf. Er ermöglicht es, den piezoelektrischen Transformator 3 mit einer sinusförmigen Spannung zu betreiben. Die beiden Schalter 7 werden komplementär zueinander angesteuert, so dass stets einer der Schalter 7 geöffnet ist und einer der Schalter 7 geschlossen ist. Auch hier erfolgt eine Reglung der Ansteuerfrequenz in Abhängigkeit der mittleren Stromstärke des Stroms über eine der Induktivitäten 8.

Das dritte Ausführungsbeispiel erfordert mehr Bauteile als die ersten zwei Ausführungsbeispiele, bietet aber den Vorteil, dass die Verluste am piezoelektrischen Transformator 3 geringer sind.

Als Steuereinheit 16 kann gemäß dem dritten Ausführungsbeispiel ein Mikrocontroller 17 oder ein Voltage Controlled Oscillator 20 verwendet werden.

### Bezugszeichenliste

- 1: Plasmagenerator
- 2: Ansteuerschaltung
- 3: piezoelektrischer Transformator
- 4: erste Außenelektrode
- 5: zweite Außenelektrode
- 6: Klasse-E Verstärker
- 7: Schalter
- 8: Induktivität
- 9: Diode
- 10: Spannungsquelle
- 11: Knotenpunkt
- 12: Pfad
- 13: Pfad
- 14: Pfad
- 15: Referenzpotential
- 16: Steuereinheit
- 17: Mikrocontroller
- 18: Messeinheit
- 19: RC-Tiefpass
- 20: Voltage Controlled Oscillator
- 21: PI-Regler
- 22: Referenzspannungsquelle
- 23: zweiter Klasse-E Verstärker

## Patentansprüche

1. Ansteuerschaltung (2),
die dazu ausgestaltet ist, an einen piezoelektrischen Transformator (3) eine Spannung mit einem periodischen Verlauf anzulegen, deren Periodendauer durch eine Ansteuerfrequenz festgelegt ist,
wobei die Ansteuerschaltung (2) eine Induktivität (8) und eine Steuereinheit (16) aufweist, und
wobei die Steuereinheit (16) dazu ausgestaltet ist, die Ansteuerfrequenz der angelegten Spannung in Abhängigkeit von einer mittleren Stromstärke eines durch die Induktivität (8) fließenden Stroms anzupassen,
**dadurch gekennzeichnet, dass** die Steuereinheit (16) dazu ausgestaltet ist, die Ansteuerfrequenz zu erhöhen, wenn die mittlere Stromstärke einen vorbestimmten Zielwert überschreitet und wobei die Steuereinheit (16) dazu ausgestaltet ist, die Ansteuerfrequenz zu verringern, wenn die mittlere Stromstärke den vorbestimmten Zielwert unterschreitet.

2. Ansteuerschaltung (2) gemäß Anspruch 1,
wobei die Ansteuerfrequenz derart eingestellt wird, dass sie zwischen einer Resonanzfrequenz und einer Antiresonanzfrequenz des piezoelektrischen Transformators (3) liegt.

3. Ansteuerschaltung (2) gemäß einem der vorherigen Ansprüche,
wobei die angelegte Spannung einen halbsinusförmigen Verlauf oder einen sinusförmigen Verlauf aufweist.

4. Ansteuerschaltung (2) gemäß einem der vorherigen Ansprüche,
aufweisend eine Messeinheit (18) zur Messung des mittleren Stroms über die Induktivität (8) aufweist, die in Reihe mit der Induktivität (8) geschaltet ist, wobei die Messeinheit (18) einen Shunt-Widerstand, einen Hall-Sensor oder einen Stromtransformator aufweist.

5. Ansteuerschaltung (2) gemäß einem der vorherigen Ansprüche,
wobei die Steuereinheit (16) einen Mikrocontroller (17) oder einen Voltage Controlled Oscillator (20) aufweist.

6. Ansteuerschaltung (2) gemäß einem der vorherigen Ansprüche,
wobei die Ansteuerschaltung (2) einen Schalter (7) aufweist, wobei die Steuereinheit (16) dazu ausgestaltet ist, den Schalter (7) periodisch zu betätigen, wobei die Ansteuerfrequenz durch eine Periodendauer der Betätigung des Schalters (7) festgelegt wird.

7. Ansteuerschaltung (2) gemäß einem der vorherigen Ansprüche,
wobei die Ansteuerschaltung einen Klasse-E Verstärker (6) aufweist, der einen Schalter (7) und die Induktivität (8) aufweist.

8. Plasmagenerator (1),
aufweisend eine Ansteuerschaltung (2) gemäß einem der Ansprüche 1 bis 7 und einen piezoelektrischen Transformator (3), der zwei Außenelektroden (4, 5) aufweist, wobei die Ansteuerschaltung (2) dazu ausgestaltet ist, eine Spannung zwischen den Außenelektroden (4, 5) des piezoelektrischen Transformators (3) anzulegen.

9. Verfahren zur Ansteuerung eines piezoelektrischen Transformators (3),
wobei der piezoelektrische Transformator (3) mit einer Ansteuerschaltung (2) verbunden ist, die dazu ausgestaltet ist, an den piezoelektrischen Transformator (3) eine Spannung anzulegen und die eine Induktivität (8) aufweist,
wobei das Verfahren die folgenden Schritte aufweist:
- Anlegen einer Spannung mit einem periodischen Verlauf, deren Periodendauer durch eine Ansteuerfrequenz festgelegt ist, an den piezoelektrischen Transformator (3),
- Messen einer mittleren Stromstärke eines durch die Induktivität (8) fließenden Stroms, und
- Regeln der Ansteuerfrequenz in Abhängigkeit von der gemessenen mittleren Stromstärke, wobei die Ansteuerfrequenz erhöht wird, wenn die mittlere Stromstärke einen vorbestimmten Zielwert überschreitet und wobei Ansteuerfrequenz verringert wird, wenn die mittlere Stromstärke den vorbestimmten Zielwert unterschreitet.

10. Verfahren gemäß Anspruch 9,
wobei in dem Schritt Anlegen einer periodischen Spannung zunächst eine Spannung mit einer Ansteuerfrequenz an den piezoelektrischen Transformator (3) angelegt wird, die unter einer Antiresonanzfrequenz des piezoelektrischen Transformators (3) liegt, und
wobei dann die Ansteuerfrequenz schrittweise reduziert wird bis die mittlere Stromstärke eines durch die Induktivität (8) fließenden Stroms einen vorbestimmten Grenzwert überschreitet.

## Claims

1. A control circuit (2) which is configured to apply a voltage having a periodic curve, the periodic duration of which is fixed by a control frequency, to a piezoelectric transformer (3),
wherein the control circuit (2) has an inductor (8) and a control unit (16), and
wherein the control unit (16) is configured to adjust the control frequency of the applied voltage as a function of an average current intensity of a current flowing through the inductor (8), **characterised in that** the control unit (16) is configured to increase the control frequency if the average current intensity exceeds a predetermined target value and wherein the control unit (16) is configured to reduce the control frequency if the average current intensity falls below the predetermined target value.

2. The control circuit (2) according to Claim 1,
wherein the control frequency is adjusted in such a way that it lies between a resonance frequency and an antiresonance frequency of the piezoelectric transformer (3).

3. The control circuit (2) according to any one of the preceding claims,
wherein the applied voltage has a semi-sinusoidal curve or a sinusoidal curve.

4. The control circuit (2) according to any one of the preceding claims,
having a measuring unit (18) for measuring the average current via the inductor (8) which is connected in series with the inductor (8), wherein the measuring unit (18) has a shunt resistor, a Hall sensor or a current transformer.

5. The control circuit (2) according to any one of the preceding claims,
wherein the control unit (16) has a microcontroller (17) or a voltage-controlled oscillator (20).

6. The control circuit (2) according to any one of the preceding claims,
wherein the control circuit (2) has a switch (7), wherein the control unit (16) is configured to operate the switch (7) periodically, wherein the control frequency is fixed by a periodic duration of the operation of the switch (7).

7. The control circuit (2) according to any one of the preceding claims,
wherein the control circuit has a class-E amplifier (6) which has a switch (7) and the inductor (8).

8. A plasma generator (1),
having a control circuit (2) according to any one of Claims 1 to 7 and a piezoelectric transformer (3) which has two outer electrodes (4, 5), wherein the control circuit (2) is configured to apply a voltage between the outer electrodes (4, 5) of the piezoelectric transformer (3).

9. A method for controlling a piezoelectric transformer (3),
wherein the piezoelectric transformer (3) is connected to a control circuit (2) which is configured to apply a voltage to the piezoelectric transformer (3) and which has an inductor (8),
wherein the method has the following steps:
- applying a voltage having a periodic curve, the periodic duration of which is fixed by a control frequency, to the piezoelectric transformer (3),
- measuring an average current intensity of a current flowing through the inductor (8), and
- regulating the control frequency as a function of the measured average current intensity, wherein the control frequency is increased if the average current intensity exceeds a predetermined target value and wherein the control frequency is reduced if the average current intensity falls below the predetermined target value.

10. The method according to Claim 9,
wherein, in the step involving applying a periodic voltage, a voltage having a control frequency is initially applied to the piezoelectric transformer (3), which lies below an antiresonance frequency of the piezoelectric transformer (3), and
wherein the control frequency is then gradually reduced until the average current intensity of a current flowing through the inductor (8) exceeds a predetermined threshold.

## Revendications

1. Circuit de commande (2),
conçu pour appliquer une tension présentant une allure périodique, dont la durée de période est fixée par une fréquence de commande, au niveau d'un transformateur piézoélectrique (3),
le circuit de commande (2) présentant un inducteur (8) et une unité de commande (16) et
l'unité de commande (16) étant conçue pour adapter la fréquence de commande de la tension appliquée en fonction d'une intensité moyenne de courant d'un courant passant à travers l'inducteur (8), **caractérisé en ce que** l'unité de commande (16) est conçue pour augmenter la fréquence de commande lorsque l'intensité moyenne de courant passe au-dessus d'une valeur cible prédéfinie et l'unité de commande (16) étant conçue pour diminuer la fréquence de commande lorsque l'intensité moyenne de courant passe sous la valeur cible prédéfinie.

2. Circuit de commande (2) selon la revendication 1,
la fréquence de commande étant réglée de manière telle qu'elle se situe entre une fréquence de résonance et une fréquence d'antirésonance du transformateur piézoélectrique (3) .

3. Circuit de commande (2) selon l'une quelconque des revendications précédentes,
la tension appliquée présentant une allure de forme semi-sinusoïdale ou une allure de forme sinusoïdale.

4. Circuit de commande (2) selon l'une quelconque des revendications précédentes,
présentant une unité de mesure (18) pour mesurer le courant moyen via l'inducteur (8), qui est commutée en série avec l'inducteur (8), l'unité de mesure (18) présentant une résistance shunt, un capteur à effet Hall ou un transformateur de courant.

5. Circuit de commande (2) selon l'une quelconque des revendications précédentes,
l'unité de commande (16) présentant un microcontrôleur (17) ou un oscillateur à tension contrôlée (20).

6. Circuit de commande (2) selon l'une quelconque des revendications précédentes,
le circuit de commande (2) présentant un commutateur (7), l'unité de commande (16) étant conçue pour actionner périodiquement le commutateur (7), la fréquence de commande étant fixée par une durée de période de l'actionnement du commutateur (7).

7. Circuit de commande (2) selon l'une quelconque des revendications précédentes,
le circuit de commande présentant un amplificateur de classe E (6), qui présente un commutateur (7) et l'inducteur (8).

8. Générateur de plasma (1),
présentant un circuit de commande (2) selon l'une quelconque des revendications 1 à 7 et un transformateur piézoélectrique (3) qui présente deux électrodes externes (4, 5), le circuit de commande (2) étant conçu pour appliquer une tension entre les électrodes externes (4, 5) du transformateur piézoélectrique (3).

9. Procédé pour la commande d'un transformateur piézoélectrique (3),
le transformateur piézoélectrique (3) étant relié à un circuit de commande (2) conçu pour appliquer une tension au niveau du transformateur piézoélectrique (3) et qui présente un inducteur (8),
le procédé présentant les étapes suivantes :
- application d'une tension présentant une allure périodique dont la durée de période est fixée par une fréquence de commande, au niveau d'un transformateur piézoélectrique (3),
- mesure d'une intensité moyenne d'un courant passant à travers l'inducteur (8) et
- régulation de la fréquence de commande en fonction de l'intensité moyenne mesurée du courant,
la fréquence de commande étant augmentée lorsque l'intensité moyenne de courant passe au-dessus d'une valeur cible prédéfinie et la fréquence de commande étant diminuée lorsque l'intensité moyenne de courant passe sous la valeur cible prédéfinie.

10. Procédé selon la revendication 9,
où, dans l'étape d'application d'une tension périodique, on applique d'abord une tension présentant une fréquence de commande au niveau du transformateur piézoélectrique (3), qui est située sous la fréquence d'antirésonance du transformateur piézoélectrique (3), et
la fréquence de commande est ensuite réduite graduellement jusqu'à ce que l'intensité moyenne d'un courant passant à travers l'inducteur (8) passe au-dessus d'une valeur limite prédéfinie.
